# EUROPÄISCHE PATENTSCHRIFT

(11) **EP 3 944 036 B1**
(45) Veröffentlichungstag und Bekanntmachung des Hinweises auf die Patenterteilung: **03.09.2025**
(21) Anmeldenummer: 21184955.9
(22) Anmeldetag: 12.07.2021
(51) Int. Cl.: G05B 19/042, G01D 21/00

(54) **VERFAHREN ZUM AUSLESEN VON GERÄTEPARAMETERN EINER ELEKTRISCHEN EINHEIT SOWIE EINE ENTSPRECHENDE ELEKTRISCHE EINHEIT**
METHOD FOR READING DEVICE PARAMETERS OF AN ELECTRICAL UNIT AND CORRESPONDING ELECTRICAL UNIT
PROCÉDÉ DE LECTURE DE PARAMÈTRES D'APPAREIL D'UNE UNITÉ ÉLECTRIQUE, AINSI QUE D'UNITÉ ÉLECTRIQUE CORRESPONDANTE

(30) Priorität: 22.07.2020 DE 102020119359; 08.07.2021 DE 102021117624
(43) Veröffentlichungstag der Anmeldung: 26.01.2022
(73) Patentinhaber: Turck Holding GmbH, 58553 Halver (DE)
(72) Erfinder: Schwagmann, Hermann, 32760 Detmold (DE); Kriegel, Thomas, 58515 Lüdenscheid (DE)
(74) Vertreter: DTS Patent- und Rechtsanwälte PartmbB

(56) Entgegenhaltungen:
- EP-B1- 3 005 248
- DE-A1- 102012 112 687
- US-B2- 10 114 408

## Beschreibung

Die vorliegende Erfindung betrifft ein Verfahren zum Auslesen von Geräteparametern einer elektrischen Einheit sowie eine entsprechende elektrische Einheit.

In Feldgeräten gespeicherte Daten zur Konfiguration werden bei einem Ersatz eines Feldgerätes vorteilhafterweise für das neue Gerät übernommen. In der DE 10 2011 089 346 A1 wird hierzu ein Verfahren zum Betreiben eines Feldgerätes der Prozessautomatisierungstechnik beschrieben, um die Grundfunktion des Feldgerätes zur Verfügung zu stellen, selbst wenn die Energieversorgung des Feldgerätes bspw. über den Feldbus ausgefallen sein sollte.

Aus der EP 3 005 248 B1 ist ein System zum Verwalten einer Prozesssteuerung mittels RFID-Geräten bekannt. Ferner ist aus der DE 10 2012 112687 A1 ist ein Feldgerät der Prozessautomatisierungstechnik bekannt, bei dem Parameter des Feldgeräts gespeichert werden und beim Ausfall des Geräts drahtlos ausgelesen werden können.

Bei einem Totalausfall des Feldgerätes oder einer anderen elektrischen Einheit kann es hingegen zeitaufwendig sein, im nachhinein den Fehler zu suchen, der zum Ausfall geführt hat. Dies können beispielsweise Umwelteinflüsse (Vibration, Feuer, Druck, etc.) oder auch Bedienfehler (Unterbrechung eines Updates) gewesen sein.

Microcontroller-basierte elektronische Schaltungen, wie sie in elektrische Einheiten eingesetzt werden, beispielsweise in einer Feldbusstation mit Kommunikationsschnittstellen und Ein-/Ausgängen, in einer Sensoreinheit oder in Infrastrukturkomponenten wie Switches, sind vielen schädigenden Umweltbedingungen ausgesetzt und/oder können durch eine Falschbedienung zerstört werden. Diese elektronischen Schaltungen sind durch geeignete Maßnahmen gegen derartige Umwelt- und Verwendungsbedingungen geschützt. Dazu gehören mechanische und konstruktive Lösungen wie Gehäuse, Dichtungen, Verguss, Lackierungen und Kunstoffkapselungen, die diese Schaltungen umgeben und gegen mechanische Einflüße (Schock, Vibration) schützen und Eindringen von Wasser oder anderen schädlichen Materialien verhindern. Weiter werden technische Lösungen eingesetzt, die beispielsweise zerstörerische Spannungsspitzen, Überlastungen, Überhitzungen, falsche Benutzung oder Verwendung in bestimmten Grenzen verhindern können. Alle Belastungen, die darüber hinaus auftreten können, zerstören die elektronische Schaltung oder ihre Bauteile kurz- oder langfristig. Diese werden im Normalfall für den Verwender des Geräts anhand von Bedienungsanleitungen und Normeninformationen bekannt gemacht, um sicher zu stellen, dass diese elektronischen Schaltungen nicht ausserhalb der genannten Belastungsgrenzen verwendet werden oder eine andersweitige Falschverwendung zur Zerstörung führt. Eine falsche Verwendung könnte beispielsweise eine zu hohe Umgebungstemperatur, Betrieb unter Wasser, eine zu hohe Strom- oder Spannungsbelastung oder Vibrationsbelastung sein. Eine weitere Fehlerquelle ist eine Unterbrechung der Energieversorgung während kritischer Betriebszustände eines Gerätes, das gerade beispielsweise ein Software-Update erfährt.

Trotz aller Schutzmaßnahmen und Hinweise und Einschränkungen der Bedienung tritt die Zerstörung elektronischer Schaltungen und Geräte auf. Nach der Zerstörung dieser Schaltungen oder Geräte sind sie im Zweifel nicht mehr betriebsbereit.

Aufgabe der vorliegenden Erfindung war es daher, eine elektrische Einheit bereitzustellen, bei dem eine Fehlersuche bei Totalausfall einfacher möglich ist bzw. ein Verfahren zum Auslesen von Geräteparametern oder Betriebsdaten oder Betriebszuständen einer erfindungsgemäßen elektrischen Einheit bereitzustellen, die bei Totalausfall der elektrischen Einheit ausgeführt werden kann.

Diese Aufgabe wird erfindungsgemäß gelöst durch eine elektrische Einheit mit den Merkmalen des unabhängigen Produktanspruchs sowie durch ein Verfahren mit den Merkmalen des Verfahrensanspruchs. Vorteilhafte Ausgestaltungen sind in den Unteransprüchen angegeben.

Danach wird die Aufgabe gelöst durch eine elektrische Einheit mit einer Microcontroller-basierten elektronischen Schaltung, umfassend ein mit dem Microcontroller verbundenen Speicherbausstein, der eingerichtet ist, um während des Betriebs der elektrischen Einheit Daten zu speichern, wobei eine drahtlose Schnittstelle vorgesehen ist, über die die Daten aus dem Speicherbaustein auslesbar sind.

Die elektrische Einheit kann auf verschiedene Weisen ausgebildet sein. Sie umfasst insbesondere eine elektronische Komponente, etwa eine Netzwerk- oder Steuerungskomponente, eine Ein- und/oder Ausgabeschnittstelle sowie gegebenenfalls andere elektronische Elemente.

Die elektrische Einheit ist erfindungsgemäß als elektrischer Steckverbinder ausgebildet, bei dem eingangsseitige Kontakte zumindest teilweise durch einen Steckvorgang mit einem komplementären Stecker verbindbar sind, wobei der elektrische Steckverbinder eingangs- und ausgangsseitige Kontakte aufweist. Ein solcher Steckverbinder ist etwa zum Verbinden von Kabeln und weiteren Einrichtungen geeignet. Bei einer weiteren, nicht erfindungsgemäßen Ausbildung ist die elektrische Einheit als Feldgerät ausgebildet.

Ein Feldgerät kann etwa eine Feldbusstation mit Kommunikationsschnittstellen und Ein-/Ausgängen, eine Sensoreinheit oder eine Infrastrukturkomponente wie ein Switch sein. Ein Feldgerät oder englisch "field device" kann so ausgebildet sein, dass es in direkter Beziehung mit einem Produktionsprozess steht, etwa einer Produktionsanlage. Das Feldgerät kann insbesondere als Aktor und/oder Sensor ausgebildet sein.

Der elektrische Steckverbinders ist beispielsweise zur Übertragung von elektrischer Energie und/oder von Daten geeignet.

Ein elektrischer Steckverbinder kann dabei eine elektronische Einrichtung umfassen, insbesondere eine elektronische Schaltung. Diese Schaltung ist bevorzug innerhalb eines Gehäuses des elektrischen Steckverbinders angeordnet. Zum Beispiel kann der Steckverbinder eine Sensoreinrichtung aufweisen, mittels derer ein elektrischer Betriebsparameter und/oder ein Umgebungsparameter erfassbar ist.

Ein erfassbarer Betriebsparameter kann dabei beispielsweise ein Wert sein, der dem Steckverbinder und/oder einem an diesen angeschlossenen Kabel oder einer Leitung und/oder einer angeschlossenen weiteren Einheit zugeordnet ist. Insbesondere ist der Betriebsparameter so gewählt, dass er eine Charakteristik einer Leistungs- und/oder Datenübertragung darstellt.

Bei dem Betriebsparameter kann es sich um verschiedene Größen handeln, beispielsweise Spannung und/oder Strom. Ferner können andere Größen als Betriebsparameter erfasst werden, etwa eine Kapazität, Induktivität, Widerstand, Impedanz, Frequenz, eine thermische Eigenschaft und/oder weitere Leitungscharakteristiken. Eine Feldstärke kann beispielweise mittels eines HallSensors erfasst werden.

Die Erfassung erfolgt insbesondere auf an sich bekannte Weise, etwa durch ein Sensorelement zum Messen einer Stromstärke oder einer Spannung. Der Betriebsparameter kann beispielsweise zwischen eingangs- und ausgangsseitigen Kontakten erfasst werden, etwa durch ein in Reihe oder in Serie geschaltetes Sensorelement der Sensoreinrichtung. Dabei kann die Messung bei einer Verbindung erfolgen, die zwischen einem eingangsseitigen Kontakt und einem ausgangsseitigen Kontakt besteht. Ferner kann eine Erfassung des elektrischen Betriebsparameters zwischen verschiedenen Verbindungen erfolgen, die jeweils zwischen der Verbindung zugeordneten eingangs- und ausgangsseitigen Kontakten besteht. Zum Beispiel können dadurch Potentialunterschiede zwischen zwei elektrischen Leitungen gemessen werden, die an den Steckverbinder angeschlossen sind.

Zum Beispiel können Eingangs- und/oder Ausgangsspannungen ermittelt werden, etwa über die Messung einer Stromstärke, und es kann somit eine Spannungsdifferenz zwischen Steckverbindern berechnet werden. Insbesondere wird auf diese Weise ein Spannungsabfall erfasst. Ferner kann eine Kabeltemperatur erfasst werden, die ein Hinweis für den zum Beispiel temperaturabhängigen elektrischen Widerstand der Verbindung darstellen kann. Ferner kann eine Zustandsüberwachung für ein angeschlossenes Kabel implementiert werden, etwa um ein beschädigtes Kabel zu identifizieren.

Dabei können beispielsweise ein Microcontroller und/oder eine Speichereinheit und/oder eine Spannungsversorgungschaltung direkt in den Steckverbinder integriert sein.

Ein erfassbarer Umgebungsparameter kann verschiedene Eigenschaften einer räumlichen Umgebung der elektrischen Einheit betreffen, etwa eine Temperatur, Feuchtigkeit, Druck, Vibrationen, Geschwindigkeit oder Beschleunigung.

Eine Sensoreinheit des elektrischen Steckverbinders kann zudem zum Erfassen eines übertragenen Datenvolumens und/oder einer Übertragungsrate eingerichtet sein.

Die elektrische Einheit kann ferner auf andere Weise ausgebildet sein, etwa als ein Gerät, das auf andere Weise als einen Feldbus ansteuerbar ist oder das ohne äußere Ansteuerung arbeitet.

Die elektrische Einheit kann ferner einen RFID-Schreib-Lese-Kopf umfassen oder als solcher ausgebildet sein; eine solche Einheit kann wiederum als Feldgerät oder Sensor ausgebildet sein.

Die elektrische Einheit kann ferner ein Gerät zum Erfassen und Speichern von Daten ausgebildet sein, etwa als stand-alone Datenlogger; beispielsweise kann die elektrische Einheit dazu eingerichtet sein, einen Umgebungsparameter zu erfassen und/oder zu protokollieren, wie etwa eine Temperatur, eine Luftfeuchtigkeit oder Vibrationen. Im Falle einer Beschädigung der elektrischen Einheit, etwa eines Datenloggers durch zu extreme Bedingungen, können dann die Daten dennoch auslesbar sein.

Die elektrische Einheit kann ferner ein mobiles Endgerät umfassen oder als solches ausgebildet sein, etwa eine Handheld-Einheit zum Erfassen und/oder Ausgeben von Daten.

Die elektrische Einheit kann ferner als ein Gerät ausgebildet sein, welches ein Nutzer am Körper oder an seiner Kleidung trägt, insbesondere sogenannte *"Wearables".*

Als Mikrocontroller (auch µController, µC, MCU) werden vor allem Halbleiterchips bezeichnet, die einen Prozessor und zugleich auch Peripheriefunktionen enthalten. In vielen Fällen befindet sich auch der Arbeits- und Programmspeicher teilweise oder komplett auf demselben Chip. Ein Mikrocontroller ist ein Ein-Chip-Computersystem. Für manche Mikrocontroller wird auch der Begriff System-on-a-Chip oder SoC verwendet. Bevorzugt finden sich auf Mikrocontrollern auch komplexe Peripheriefunktionen wie z. B. CAN- (Controller Area Network), LIN-(Local Interconnect Network), USB- (Universal Serial Bus), I2C- (Inter-Integrated Circuit), SPI- (Serial Peripheral Interface), serielle oder Ethernet-Schnittstellen, PWM-Ausgänge, LCD-Controller und -Treiber sowie Analog-Digital-Umsetzer. Bevorzugt verfügen Mikrocontroller auch über programmierbare digitale und/oder analoge bzw. hybride Funktionsblöcke.

Der Speicherbausstein ist bevorzugt ein gesonderter Speicherbaustein, der vom Mikrocontroller getrennt ausgeführt ist und mit dem Mikrocontroller lediglich verbunden ist. Es ist auch möglich, dass der Speicherbaustein mit dem Mikrocontroller zusammen aufgebaut ist und sich der Speicherbaustein auf demselben Chip wie der Mikrocontroller befindet. Der Speicherbaustein kann auch in einem Tag der drahtlosen Schnittstelle integriert sein, insbesondere in einem RFID-/NFC-Tag. Der Speicherbaustein kann eine erste Schnittstelle aufweisen, mit der er an den Mikrocontroller anschließbar ist und eine zweite Schnittstelle aufweisen, die drahtlos ist und über die er auslesbar ist und bevorzugt auch beschreibbar ist.

Der Speicherbaustein ist eingerichtet, um während des Betriebs der elektrischen Einheit Daten bzw. Informationen zu speichern. Diese Daten bzw. Informationen können wertvolle Applikationsinformationen beinhalten (Konfiguration des Gerätes, Rezepte, Verwendungsinformationen, etc.), aber auch anderweitige Betriebsinformationen wie die Anzahl der ermittelten Überspannungen während des Betriebes, und/oder gemessene Umgebungswerte wie Temperatur, Feuchtigkeit, Betriebsstunden oder letzte Zustandinformationen wie "befinde mich in der Updatefunktion der Betriebssoftware" oder "Spannungsspitze dedektiert", "Umgebungstemperatur zu hoch" etc. Hierzu ist der Speicherbaustein bevorzugt mit dem Microcontroller elektrisch leitend verbunden, besonders bevorzugt ebenfalls über eine drahtlose Schnittstelle.

Die drahtlose Schnittstelle, über die die Daten aus dem Speicherbaustein auslesbar sind, ist bevorzugt als eigenes Bauteil ausgebildet und mit dem Speicher verbunden. Hierüber ist es möglich, die Daten im Speicherbaustein auch dann auszulesen, wenn der Mikrocontroller nicht mehr ansprechbar ist. Besonders bevorzugt ist die drahtlose Schnittstelle, über die die Daten aus dem Speicherbaustein auslesbar sind, integral mit dem Speicher ausgebildet.

Durch die Ergänzung einer solchen Microcontroller-basierten elektronischen Schaltung in einer elektrischen Einheit durch ein mit dem Microcontroller verbundenen Speicherbausstein, der bevorzugt auch als passiver NFC-Tag ansprechbar ist, können die Daten, die auf dem Speicherbaustein im Betrieb gespeichert worden sind, unabhängig vom Zustand der restlichen Komponenten ausgelesen und durch Auswertung ermittelt werden, was zum (Total-)Ausfall des Feldgeräts geführt hat. Informationen, die auf diesem Speicherbausstein hinterlegt worden sind, können so "post-mortem" ausgelesen werden. Somit ist es möglich, über eine ansonsten nicht mehr betriebsbereite Schaltung (oder ein Gerät) noch beispielsweise über einen von aussen herangeführten RFID-Reader Informationen zu gewinnen.

Speicherbausteine können oftmals auch aus der zerstörten Schaltungen herausgelöst werden und in funktionierenden elektronischen Schaltungen oder Systemen eingesetzt oder angesprochen werden. Dadurch werden die wertvollen Informationen wieder verfügbar. Dies ist aber aufwendiger als das Auslesen der Daten über die drahtlose Schnittstelle, insbesondere wenn die Bausteine beispielsweise vergossen oder lackiert sind bzw. anderweitig nicht technisch leicht zugänglich sind und damit nicht zerstörungsfrei entfernt werden können - gegebenenfalls nur durch thermische Behandlung oder chemische Freisetzung. Elektronische Schaltungen und Geräte können somit trotz der nicht mehr möglichen Inbetriebnahme "post mortem" analysiert werden. Erkenntnisse darüber können als Nachweis einer Falschbehandlung dienen und Gewährleistungs- oder Schadensersatzansprüche vermeiden oder wertvolle Informationen über den Zustands des Gerätes liefern, um eine Fehlerbehebung eines Gerätetyps zu vereinfachen.

Bei einer vorteilhaften elektrischen Einheit ist der Speicherbaustein eingerichtet, um als passiver RFID-Tag ansprechbar zu sein. Einer solchen Microcontroller-basierten elektronischen Schaltung wird damit ein mit dem Microcontroller verbundener Speicherbausstein hinzugefügt, der auch als passiver RFID-Tag ansprechbar ist. Es ist ebenfalls möglich, einen HF-RFID-Tag oder einen NFC-Tag einzusetzen. Bevorzugt wird eine Kombination von mehreren Tags genutzt, um die Redundanz zu erhöhen. Es kann sich dabei um mehrere baugleiche Tags handeln oder um mehrere Tags unterschiedlicher Bauart, d.h. RFID-Tag, HF-RFID-Tag oder NFC-Tag in Kombination bzw. Tags unterschiedlicher Speicherkapazität in Kombination. Hierdurch ist es auch möglich, unterschiedliche Inhalte auf die unterschiedlichen Speicher der einzelnen Tags zu speichern und damit über unterschiedliche Tags und deren drahtlose Schnittstellen wieder abzurufen.

Über diesen RFID-Tag können auch vor der Havarie des Gerätes Informationen über die drahtlose Schnittstelle ausgelesen werden und es ist bevorzugt auch möglich, Informationen über die drahtlose Schnittstelle auf den Speicherbaustein des Tags zu schreiben. Damit können beispielsweise Wartungs- oder Inspektionsdaten auf dem Speicherbaustein abgelegt werden oder ältere Daten auch gelöscht werden.

Bevorzugt werden Tags eingesetzt, die zur drahtlosen Schnittstelle zusätzlich eine Schnittstelle zum Microcontroller aufweisen. Der RFID-Tag mit dem Speicherbaustein ist damit der Datenträger für die geloggten Daten.

Weiterhin bevorzugt ist eine elektrische Einheit vorgesehen, bei dem der Speicherbaustein einen Transponder, vorzugsweise gemäß dem NFC- und/oder dem RFID-Standard, aufweist.

Die Near Field Communication (dt. Nahfeldkommunikation, abgekürzt NFC) ist ein auf der RFID-Technik basierender internationaler Übertragungsstandard zum kontaktlosen Austausch von Daten per elektromagnetischer Induktion mittels loser gekoppelter Spulen über kurze Strecken von wenigen Zentimetern und einer Datenübertragungsrate von maximal 424 kBit/s.

RFID (englisch radio-frequency identification "Identifizierung mit Hilfe elektromagnetischer Wellen") bezeichnet eine Technologie für Sender-Empfänger-Systeme zum automatischen und berührungslosen Identifizieren und Lokalisieren von Objekten und Lebewesen mit Radiowellen.

Ein RFID-System besteht in der Regel aus einem Transponder (umgangssprachlich auch Funketikett genannt), der sich am oder im Gegenstand, hier also bevorzugt dem Speicherbaustein, befindet und einen kennzeichnenden Code enthält, sowie einem Lesegerät zum Auslesen dieser Kennung.

Es besteht die Möglichkeit, RFID-Transponder über ein spezielles Druckverfahren stabiler Schaltungen aus Polymerenherzustellen.

Die Kopplung geschieht bevorzugt durch vom Lesegerät erzeugte magnetische Wechselfelder in geringer Reichweite oder durch hochfrequente Radiowellen. Damit werden bevorzugt nicht nur Daten übertragen, sondern auch der Transponder mit Energie versorgt.

Das Lesegerät enthält bevorzugt eine Software (ein Mikroprogramm), die den eigentlichen Leseprozess steuert, und besonders bevorzugt auch eine RFID-Middleware mit Schnittstellen zu weiteren EDV-Systemen und Datenbanken.

Weiterhin bevorzugt ist eine elektrische Einheit vorgesehen, bei dem der Speicherbaustein und/ oder der Microcontroller technisch nicht zugänglich eingebaut sind/ ist. Dadurch können die Bausteine vor Umwelteinflüssen und Beschädigungen geschützt werden.

Weiterhin bevorzugt ist eine elektrische Einheit vorgesehen, bei dem die Daten Stationsparameter des Gerätes oder weitere Betriebsparameter umfassen.

Hierbei umfassen Stationsparameter bevorzugt notwendige Konfigurationsdaten, z.B. Geräteparameter, aber auch Produktionsdaten.

Betriebsparameter umfassen bevorzugt alles, was der Mikrocontroller erfasst und neben den Stationsparametern zur Laufzeit in den Speicher lädt, z.B. (Betriebs- )Spannungswerte, Reset-Gründe, Bootloadermodus und/oder weitere markante Speicherinhalte. Es können auch Daten zur Temperatur, Vibration, Strahlung, Laufzeitfehlercodes, Zustände, Kommunikationsparameter erfasst werden. Der Zustand kann umfassen den laufenden Prozessdatenaustausch, Konfigurationsmodus, Hochlaufphase, Datenraten im Netzwerk. Bei der Betriebsspannung können insbesondere Ladezustand des Akku oder der Batterie erfasst werden.

Die Aufgabe wird auch gelöst durch ein Verfahren zum Auslesen von Geräteparametern einer erfindungsgemäßen elektrischen Einheit, wobei zur Laufzeit der elektrischen Einheit Daten in dem Speicherbaustein gespeichert wurden und die elektrische Einheit dann einen Defekt aufweist, bei dem die elektrische Einheit nicht über kabelgebundene Wege kommunizieren kann und der Microcontroller bzw. die Verarbeitungseinheit der elektrischen Einheit nicht mehr angesprechbar ist und die elektrische Einheit an keiner Spannungsversorgung angeschlossen ist, weiter umfassend den Schritt:
- Auslesen der Daten aus dem Speicherbaustein über die drahtlose Schnittstelle, wobei die elektrische Einheit als elektrischer Steckverbinder ausgebildet ist, bei dem eingangsseitige Kontakte zumindest teilweise durch einen Steckvorgang mit einem komplementären Stecker verbindbar sind, wobei der elektrische Steckverbinder eingangs- und ausgangsseitige Kontakte aufweist.

Weiterhin bevorzugt ist ein Verfahren vorgesehen, weiter umfassend den Schritt:
- das Auslesen der Daten aus dem Speicherbaustein über die drahtlose Schnittstelle erfolgt mittels RFID oder NFC.

Weiterhin bevorzugt ist ein Verfahren vorgesehen, weiter umfassend den Schritt:
- Anzeigen der ausgelesenen Daten auf einem mobilen Endgerät. Als mobiles Endgerät kann ein tragbarer Computer, ein Smartphone oder ein Lesegerät eingesetzt werden.

Weiterhin bevorzugt ist ein Verfahren vorgesehen, weiter umfassend den Schritt: Interpretation der ausgelesenen Daten anhand einer vorgegebenen Auswertungszuordnung.

Bevorzugt ist diese Auswertungszuordnung in einer Datenbank strukturiert. Die Datenbank ist bevorzugt standortunabhängig aufrufbar, insbesondere über das Internet bzw. über einen Webzugriff. Bevorzugt ist die Datenbank eingerichtet, um zentral um produktbezogene Fehlercodes oder Zustandcodes ergänzt zu werden. Die Datenbank ist bevorzugt so eingerichtet, dass über Identifikationsmerkmale des Produktes (Produktname, ID, Chargencode) entsprechende Fehlercodes oder Zustandcodes textuell (menschlich les- und interpretierbar) ausgebbar sind.

Weitere Einzelheiten und Vorteile der Erfindung sollen nun anhand eines in der Zeichnung dargestellten Ausführungsbeispiels näher erläutert werden.

Es zeigt:

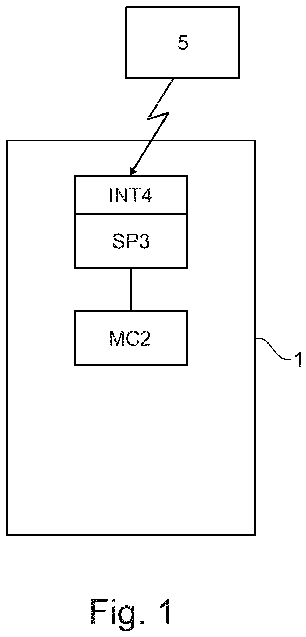

- Fig. 1: eine schematische Darstellung einer elektrischen Einheit mit einer Microcontroller basierten Schaltung.

Fig 1 zeigt eine schematische Darstellung einer elektrischen Einheit (1), die bei dem Ausführungsbeispiel als Feldgerät (1) ausgebildet ist, mit einer Microcontroller basierten Schaltung, umfassend einen Microcontroller (MC2) und eine hiermit verbundenen Speicherbaustein (SP3). Es ist außerdem eine drahtlose Schnittstelle (INT4) vorgesehen.

Im Betrieb werden Daten durch den Microcontroller (MC2) auf den Speicherbaustein (SP3) geschrieben.

Über die drahtlose Schnittstelle (INT4) werden die Daten an ein mobiles Endgerät (5) übertragen.

Bevorzugt handelt es sich bei dem Speicherbaustein (SP3) und der drahtlosen Schnittstelle um einen RFID-Tag. Dieser RFID-Tag ist mit dem Mictrocontroller (MC2) verbunden und ist eingerichtet, die Daten, die vom Microcontroller (MC2) zur Verfügung gestellt werden, zu speichern. Es kann sich hierbei um Daten wie Zustände handeln, beispielsweise, dass gerade ein Update lädt und installiert wird, oder Umweltparameter wie Temperatur, Vibration oder Feuchtigkeit.

Fällt die elektrische Einheit (1) nun aus und ist der Microcontroller (MC2) nicht mehr ansprechbar, kann mit einem mobilen Endgerät (5), beispielsweise einem Laptop oder einem Smartphone über die Schnittstelle (INT4) der Inhalt des Speicherbausteins (SP3), d.h. des RFID-Tags ausgelesen werden. Die dort gewonnen Daten können dann auf dem mobilen Endgerät (5) angezeigt werden und durch Interpretation der ausgelesenen Daten anhand einer vorgegebenen Auswertungszuordnung visualisiert werden. So können die Daten ausgewertet werden und dem Bediener des mobilen Endgeräts (5) auf einem Display angezeigt werden, dass ein Update installiert wurde und dabei eine erhöhte Vibration aufgetreten war und kurz danach die Betriebsspannung abgefallen ist.

Mit der erfindungsgemäßen elektrischen Einheit und dem Verfahren zum Auslesen von Parametern aus dieser elektrischen Einheit ist eine Möglichkeit geschaffen, auch nach einer Havarie festzustellen, welche Umstände zum Versagen des Gerätes geführt haben, indem diese Daten "post mortem" über die drahtlose Schnittstelle auslesbar ist, ohne dass es einer aufwendigen Analyse und mechanischen Herauslösung von beispielsweise vergossenen Teilen bedarf.

Erfindungsgemäß ist die elektrische Einheit (1) ausgebildet als elektrischer Steckverbinder. Die Funktionsweise ist im Prinzip gleich wie oben für ein Feldgerät (1) beschrieben.

Bei einem Ausführungsbeispiel umfasst die elektrische Einheit (1), etwa eine elektrischer Steckverbinder, ein Sensorelement. Das Sensorelement ist bei diesem Ausührungsbeispiel zum Erfassen von Betriebs- und Umgebungparametern ausgbildet. Während des Betriebs der elektrischen Einheit (1) werden Parameter wie eine Umgebungstemperatur, eine übertragene Spannung, Strom oder Leistung, eine Datenübertragungsrate oder eine Feldstärke gemessen und auf den Speicherbaustein (SP3) geschrieben.

Beispielsweise kann ein erfasster Wert eines Parameters dann auf den Speicherbaustein (SP3) geschrieben werden, wenn ein vorgegebener Schwellenwert über- oder unterschritten wird, oder wenn andere Bedingungen erfüllt sind.

Bei weiteren Ausbildungsformen der elektrischen Einheit kann mittels der über die drahtlose Schnittstelle auslesbaren Daten zudem eine elektrische Ersatzeinheit parametrisiert werden, sodass dieses anschließend die Aufgabe der havarierten Einheit zeitnah übernehmen kann.

### Bezugszeichenliste

- 1: Elektronische Einheit; Feldgerät
- 2: Mikrocontroller MC2
- 3: Speicherbaustein SP3
- 4: Drahtlose Schnittstelle INT4
- 5: Datenmobiles Endgerät

## Patentansprüche

1. Elektrische Einheit (1) mit einer Microcontroller-basierten elektronischen Schaltung, umfassend
einen mit dem Microcontroller (MC2) verbundenen Speicherbausstein (SP3), der eingerichtet ist, um während des Betriebs der elektrischen Einheit (1) Daten zu speichern, wobei
eine drahtlose Schnittstelle (INT4) vorgesehen ist, über die die Daten aus dem Speicherbaustein (SP3) auslesbar sind,
**dadurch gekennzeichnet, dass**
die elektrische Einheit (1) als elektrischer Steckverbinder ausgebildet ist, bei dem eingangsseitige Kontakte zumindest teilweise durch einen Steckvorgang mit einem komplementären Stecker verbindbar sind, wobei der elektrische Steckverbinder eingangs- und ausgangsseitige Kontakte aufweist.

2. Elektrische Einheit (1) nach einem der vorhergehenden Ansprüche, wobei der Speicherbaustein (SP3) eingerichtet ist, um als passiver RFID-Tag ansprechbar zu sein.

3. Elektrische Einheit (1) nach einem der vorhergehenden Ansprüche, wobei der Speicherbaustein (SP3) einen Transponder, vorzugsweise gem. dem NFC- und/oder dem RFID-Standard, aufweist.

4. Elektrische Einheit (1) nach einem der vorhergehenden Ansprüche, wobei der Speicherbaustein (SP3) und/ oder der Microcontroller (MC2) technisch nicht zugänglich eingebaut sind/ist.

5. Elektrische Einheit (1) nach einem der vorhergehenden Ansprüche, wobei die Daten Stationsparameter des Gerätes oder weitere Betriebsparameter umfassen.

6. Verfahren zum Auslesen von Geräteparametern einer elektrischen Einheit (1) nach einem der vorhergehenden Ansprüche, wobei zur Laufzeit der elektrischen Einheit (1) Daten in dem Speicherbaustein (SP1) gespeichert wurden
die elektrische Einheit (1) dann einen Defekt aufweist, bei dem die elektrische Einheit (1) nicht über kabelgebundene Wege kommunizieren kann und
der Microcontroller (MC1) der elektrischen Einheit (1) nicht mehr angesprechbar ist und die elektrische Einheit (1) an keiner Spannungsversorgung angeschlossen ist, weiter umfassend den Schritt:
- Auslesen der Daten aus dem Speicherbaustein (SP3) über die drahtlose Schnittstelle (INT4),
**dadurch gekennzeichnet, dass**
die elektrische Einheit (1) als elektrischer Steckverbinder ausgebildet ist, bei dem eingangsseitige Kontakte zumindest teilweise durch einen Steckvorgang mit einem komplementären Stecker verbindbar sind, wobei der elektrische Steckverbinder eingangs- und ausgangsseitige Kontakte aufweist.

7. Verfahren nach dem vorhergehenden Verfahrensanspruch, weiter umfassend den Schritt:
- das Auslesen der Daten aus dem Speicherbaustein (SP3) über die drahtlose Schnittstelle (INT4) erfolgt mittels RFID oder NFC.

8. Verfahren nach einem der vorhergehenden Verfahrensansprüche, weiter umfassend den Schritt:
- Anzeigen der ausgelesenen Daten auf einem mobilen Endgerät (5).

9. Verfahren nach einem der vorhergehenden Verfahrensansprüche, weiter umfassend den Schritt:
Interpretation der ausgelesenen Daten anhand einer vorgegebenen Auswertungszuordnung, wobei die Auswertungszuordnung in einer Datenbank strukturiert ist.

## Claims

1. Electrical unit (1) having a microcontroller-based electronic circuit, comprising
a memory module (SP3) which is connected to the microcontroller (MC2) and is configured to store data during operation of the electrical unit (1), wherein
a wireless interface (INT4) is provided and can be used to read the data from the memory module (SP3), **characterized in that**
the electrical unit (1) is in the form of an electrical plug-in connector, in which input-side contacts can be connected at least partially by a plug-in operation to a complementary plug, the electrical plug-in connector having input-side and output-side contacts.

2. Electrical unit (1) according to one of the preceding claims, wherein the memory module (SP3) is configured to be addressable as a passive RFID tag.

3. Electrical unit (1) according to one of the preceding claims, wherein the memory module (SP3) has a transponder, preferably according to the NFC and/or RFID standard.

4. Electrical unit (1) according to one of the preceding claims, wherein the memory module (SP3) and/or the microcontroller (MC2) are/is installed so as to be technically inaccessible.

5. Electrical unit (1) according to one of the preceding claims, wherein the data comprise station parameters of the device or further operating parameters.

6. Method for reading device parameters of an electrical unit (1) according to one of the preceding claims, wherein
data were stored in the memory module (SP1) at the runtime of the electrical unit (1),
the electrical unit (1) then has a defect, in the case of which the electrical unit (1) cannot communicate via wired paths and
the microcontroller (MC1) of the electrical unit (1) can no longer be addressed and the electrical unit (1) is not connected to any voltage supply, further comprising the step of:
- reading the data from the memory module (SP3) via the wireless interface (INT4),
**characterized in that**
the electrical unit (1) is in the form of an electrical plug-in connector, in which input-side contacts can be connected at least partially by a plug-in operation to a complementary plug, the electrical plug-in connector having input-side and output-side contacts.

7. Method according to the preceding method claim, further comprising the step of:
- reading the data from the memory module (SP3) via the wireless interface (INT4) using RFID or NFC.

8. Method according to one of the preceding method claims, further comprising the step of:
- displaying the data that have been read on a mobile terminal (5).

9. Method according to one of the preceding method claims, further comprising the step of:
interpreting the data that have been read by means of a predefined evaluation assignment, wherein the evaluation assignment is structured in a database.

## Revendications

1. Unité électrique (1) équipée d'un circuit électronique à microcontrôleur, comprenant un module de mémoire (SP3), relié au microcontrôleur (MC2) et conçu pour enregistrer des données pendant le fonctionnement de l'unité électrique (1),
une interface sans fil (INT4) étant prévue, par l'intermédiaire de laquelle les données sont aptes à être lues à partir du module de mémoire (SP3),
**caractérisée en ce que**
l'unité électrique (1) est conçue sous la forme **d'un** connecteur électrique enfichable, dont les contacts côté entrée sont au moins partiellement connectables par enfichage à un connecteur complémentaire, le connecteur électrique comportant des contacts côté entrée et côté sortie.

2. Unité électrique (1) selon l'une des revendications précédentes, dans laquelle le module de mémoire (SP3) est conçu de manière à être activable en tant qu'étiquette RFID passive.

3. Unité électrique (1) selon l'une des revendications précédentes, dans laquelle le module de mémoire (SP3) comprend un transpondeur, de préférence conforme à la norme NFC et/ou RFID.

4. Unité électrique (1) selon l'une des revendications précédentes, dans laquelle le module de mémoire (SP3) et/ou le microcontrôleur (MC2) est/sont installés de manière techniquement inaccessible.

5. Unité électrique (1) selon l'une des revendications précédentes, dans laquelle les données comprennent des paramètres de station de l'appareil ou d'autres paramètres de fonctionnement.

6. Procédé de lecture de paramètres d'appareil d'une unité électrique (1) selon l'une des revendications précédentes, dans lequel
des données ont été enregistrées dans le module de mémoire (SP1) pendant le fonctionnement de l'unité électrique (1)
l'unité électrique (1) présente alors un défaut dans lequel l'unité électrique (1) ne peut pas communiquer par des voies câblées, et
le microcontrôleur (MC1) de l'unité électrique (1) n'est plus accessible et l'unité électrique (1) n'est connectée à aucune alimentation électrique, comprenant en outre l'étape suivante :
- lecture des données à partir du module de mémoire (SP3) via l'interface sans fil (INT4),
**caractérisé en ce que**
l'unité électrique (1) est conçue sous la forme d'un connecteur électrique enfichable, dont les contacts côté entrée sont au moins partiellement connectables par enfichage à un connecteur complémentaire, le connecteur électrique comportant des contacts côté entrée et côté sortie.

7. Procédé selon la revendication précédente, comprenant en outre l'étape suivante :
- la lecture des données à partir du module de mémoire (SP3) via l'interface sans fil (INT4) s'effectue au moyen de la technologie RFID ou NFC.

8. Procédé selon l'une des revendications précédentes, comprenant en outre l'étape suivante :
- affichage des données lues sur un terminal mobile (5).

9. Procédé selon l'une des revendications précédentes, comprenant en outre l'étape suivante :
interprétation des données lues en utilisant une attribution d'évaluation prédéfinie, l'attribution d'évaluation étant structurée dans une base de données.
